Europäisches Patentamt

European Patent Office

Office européen des brevets

(11) Numéro de publication: **0 324 318**
**A1**

## (12) DEMANDE DE BREVET EUROPEEN

(21) Numéro de dépôt: **88810884.2**

(22) Date de dépôt: **21.12.88**

(51) Int. Cl.⁴: **H02J 9/06 , G01R 31/02**

(30) Priorité: **05.01.88 CH 20/88**

(43) Date de publication de la demande:
**19.07.89 Bulletin 89/29**

(84) Etats contractants désignés:
**DE FR GB IT SE**

(71) Demandeur: **TRANSEC FINANCIERE S.A.**
**15, boulevard Royal**
**L-1010 Luxenbourg(LU)**

(72) Inventeur: **Favre, Didier**
**5, chemin des Vignes**
**CH-1258 Perly(CH)**
Inventeur: **Lechner, Heinz**
**9, chemin de Broye**
**CH-1020 Renens(CH)**

(74) Mandataire: **Ardin, Pierre et al**
**PIERRE ARDIN & CIE 22, rue du Mont-Blanc**
**CH-1201 Genève(CH)**

(54) **Dispositif pour contrôler si un appareil ou un circuit est en liaison avec un réseau de distribution électrique.**

(57) Le circuit comprend un accumulateur (A) chargé par un redresseur (D1) à partir du réseau (P, N). Des résistances (R3, R5) sont parcourues par un courant délivré par l'accumulateur (A) par suite de l'impédance du réseau et rendent le transistor (T1) conducteur grâce à la porte (NAND 2), même en l'absence de la tension du réseau. Si le circuit est déconnecté du réseau, le transistor (T1) devient non conducteur, évitant ainsi automatiquement une décharge indésirée de l'accumulateur (A).

FIG.1

EP 0 324 318 A1

# Dispositif pour contrôler si un appareil ou un circuit est en liaison avec un réseau de distribution électrique

On connaît déjà différents dispositifs pour vérifier si le réseau électrique fournit sa tension habituelle et pour mettre en marche une source de courant auxiliaire en cas de défaillance du réseau.

Il est toutefois utile dans certains cas, de vérifier si un appareil ou un circuit est en liaison avec un réseau électrique sans que ce contrôle dépende obligatoirement de la présence ou de l'absence de la tension du réseau. Ceci est par exemple le cas lorsqu'un appareil comprend une source de courant indépendante du réseau, par exemple des piles ou un accumulateur, et que l'on désire que cette source de courant indépendante soit mise hors circuit dès que la connexion de l'appareil au réseau est interrompue.

L'invention a pour but de permettre un tel contrôle. Elle a pour objet un dispositif pour contrôler si un appareil ou un circuit est en liaison avec un réseau de distribution électrique, caractérisé en ce qu'il comprend un circuit alimenté par une source de courant indépendante du réseau, ce circuit étant sensible à l'impédance due à l'ensemble des charges branchées sur le réseau et fournissant un signal en réponse à la présence ou à l'absence de ces charges.

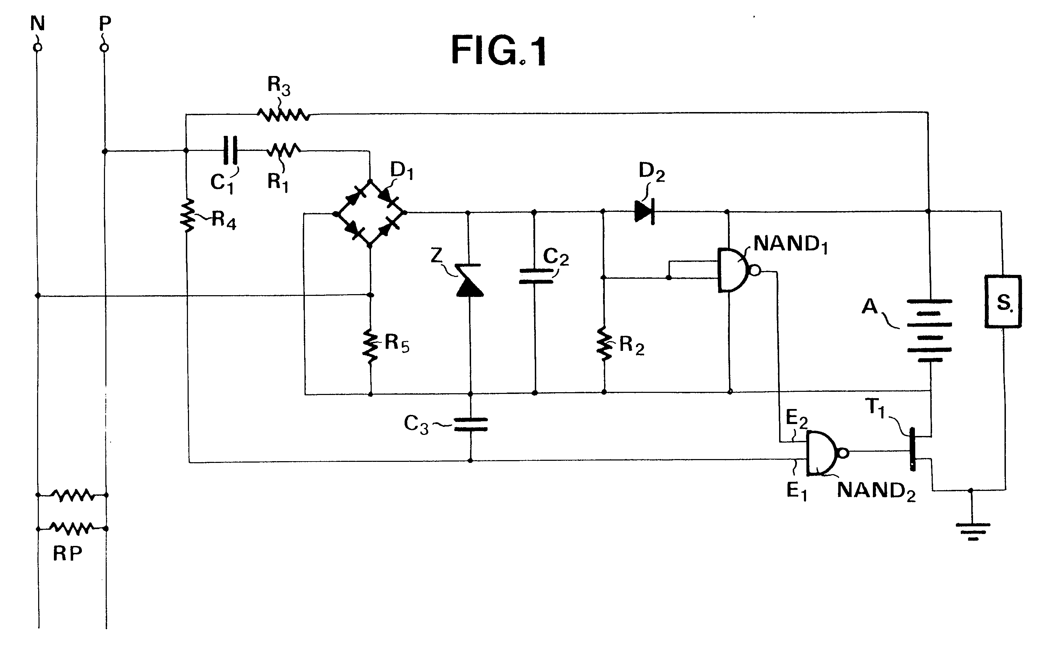

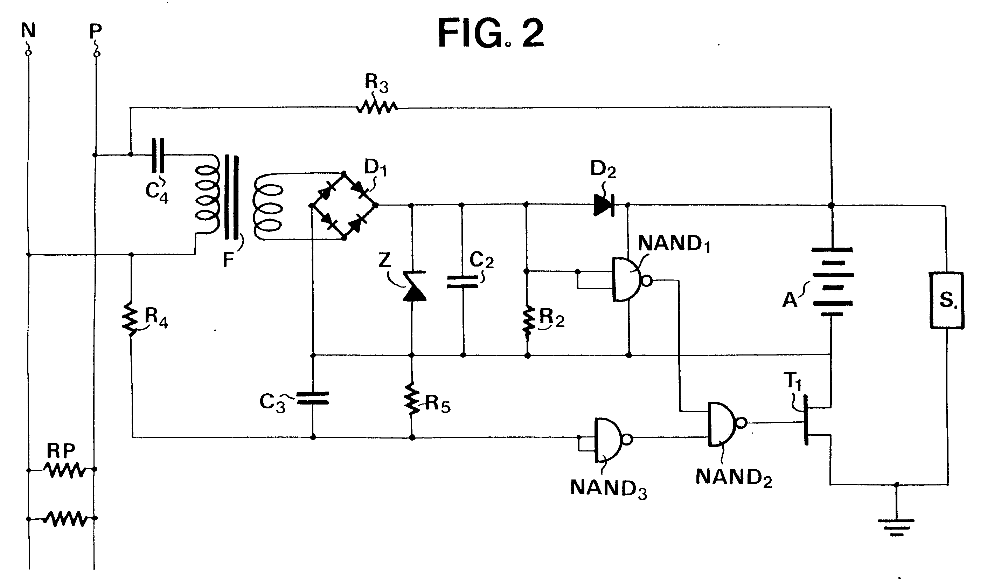

Les figures 1 et 2 du dessin annexé représentent, schématiquement et à titre d'exemple, deux formes d'exécution du dispositif faisant l'objet de l'invention.

Dans le schéma selon la figure 1, on a représenté deux lignes N et P d'un réseau de distribution qui alimente divers appareils ou circuits utilisateurs représentés schématiquement par RP.

Les lignes P et N sont reliées à un redresseur en pont D1 par l'intermédiaire d'un condensateur C1 et d'une résistance R1 en série. La tension délivrée par le pont redresseur D1 est stabilisée par une diode Zener Z et lissée par un condensateur C2. Le courant délivré par le redresseur D1 maintient sous charge un accumulateur A en passant par une diode D2 de découplage. Cet accumulateur constitue une source de courant indépendante, destinée à alimenter un circuit S, par exemple un circuit de surveillance ou d'alarme.

La tension de l'accumulateur A sert également à alimenter une porte NAND 1 et une porte NAND 2 qui servent à commander un transistor T1 à effet de champ, qui contrôle la liaison entre l'accumulateur A et le circuit S.

Les deux entrées de la porte NAND 1 sont reliées à la borne positive de la diode Zener Z d'une part et d'autre part à la borne négative de l'accumulateur A par l'intermédiaire d'une résistance R2. Cette porte 1 permet de vérifier si le redresseur D1 est alimentée par la tension du réseau. Dans ce cas, les deux entrées de la porte 1 sont au niveau élevé et sa sortie donne le signal zéro qui est appliqué sur l'entrée E2 de la porte 2. En l'absence de tension du réseau, le condensateur C2 se décharge dans la résistance R2 et le signal d'entrée de la porte 1 est zéro et son signal de sortie haut est appliqué sur l'entrée E2 de la porte 2.

Le circuit comprend encore une disposition permettant de détecter l'impédance du réseau. Il y a lieu de remarquer que si tous les utilisateurs du réseau sont débranchés, il subsiste cependant l'impédance de l'enroulement de tension du compteur électrique que l'on trouve en principe sur tous les réseaux de distribution. A cet effet, la borne positive de l'accumulateur A est reliée à la ligne de phase P par une resistance R3 de valeur élevée, par exemple de l'ordre de 1 mégohm. La ligne de phase P est également reliée à l'entrée E1 de la porte NAND 2 par une résistance R4 dont la valeur est du même ordre que celle de la résistance R3. Un condensateur C3 est branché entre l'entrée E1 et la borne négative de l'accumulateur A et constitue avec la résistance R4 un filtre qui annule pratiquement la composante alternative due au réseau et l'empêche d'atteindre l'entrée E1. Une résistance R5 relie la ligne N à la borne négative de l'accumulateur A pour fixer galvaniquement le potentiel de cette borne.

Comme on le sait, la porte NAND 2 ne donne un signal nul à sa sortie que si les deux entrées E1 et E2 reçoivent un signal élevé. Dans ces conditions, le transistor T1 ne sera pas conducteur en l'absence de la tension du réseau, pour lequel la sortie de la porte NAND 1 est élevé et conjointement en l'absence d'une connexion au réseau, car dans ce cas la borne positive de l'accumulateur A est relié à l'entrée E1 par les résistances R3 et R4 en série et applique donc un signal élevé sur cette entrée E1.

Lorsque le circuit reste branché au réseau, l'impédance de ce dernier est très faible par rapport à la valeur de la résistance R3, de sorte qu'au point de vue du courant continu de l'accumulateur A, le potentiel de l'entrée E1 correspond sensiblement au potentiel de la ligne neutre N. Il en résulte que le transistor T1 reste conducteur.

Ainsi le transistor T1 ne devient non-conducteur que lorsque le circuit décrit est déconnecté du réseau, tandis qu'il est conducteur tant que le circuit est relié au réseau, que celui-ci soit sous tension ou non. On obtient ainsi l'effet désiré, à savoir la mise hors circuit automatique de l'accumulateur dès que l'usager déconnecte l'appareil, par exemple pour le ranger.

Il est clair que la source de courant indépendante pourrait être constituée par une pile sèche et, dans ce cas, il est avantageux de lui adjoindre une diode en série pour éviter que le courant fourni par le redresseur D1 ne vienne traverser la pile en contre-courant.

Il y a lieu de noter que la possibilité offerte par ce circuit, c'est-à-dire de reconnaître s'il est connecté ou non au réseau, peut aussi être utilisée dans un autre but, notamment pour une alarme contre le sabotage. Il suffit alors de remplacer la porte NAND 2 par une porte AND pour que le transistor T1 devienne conducteur dès que le circuit est débranché du réseau et dans ce cas seulement, ce qui ferait circuler le courant de l'accumulateur A dans le circuit S.

La figure 2 montre une modification du circuit pour l'adapter au cas où ce dernier comprend un transformateur F pour relier le réseau au redresseur en pont D1. Dans ce cas, l'entrée E1 de la porte NAND 2 est reliée à la ligne N du réseau par l'intermédiaire d'une porte NAND 3 jouant le rôle d'un inverseur et par la résistance R4.

En outre, si l'on ne prenait pas de mesure particulière, le circuit ne serait plus capable de vérifier s'il est déconnecté du réseau de distribution, car il constaterait la présence de l'impédance de l'enroulement primaire du transformateur F et ne pourrait la différencier des autres impédances faisant partie du réseau. Il suffit alors de prévoir un condensateur C4 entre l'enroulement primaire du transformateur F et l'une des résistances R3 ou R4 pour obtenir un découplage entre ces résistances et l'entrée du transformateur lorsque seul le potentiel continu de l'accumulateur A est appliqué aux lignes P et N par la résistance R3 et par les résistances en série R4 et R5.

Il va de soi que l'on obtiendrait le même effet de découplage en remplaçant le condensateur C4 par un autre élément présentant une résistance élevée en dessous du coude de rupture, par exemple par une résistance à l'oxyde de zinc, ou par un "bilateral switch".

Dans le circuit de la figure 2 on peut, comme dans celui de la figure 1, choisir la porte de commande du transistor T1 de façon à obtenir soit la mise hors circuit de l'accumulateur A, soit sa mise en circuit sur un dispositif d'alarme lorsque le circuit est déconnecté du réseau.

circuit alimenté par une source de courant indépendante du réseau, ce circuit étant sensible à l'impédance due à l'ensemble des charges branchées sur le réseau et fournissant un signal en réponse à la présence ou à l'absence de ces charges.

2. Dispositif selon la revendication 1, **caractérisé** en ce qu'il comprend en outre un circuit sensible à la présence de la tension du réseau, ce circuit commandant une porte pour l'amener dans un état déterminé dès que la tension du réseau est présente et indépendamment du signal fourni par le circuit sensible à l'impédance du réseau.

3. Dispositif selon la revenication 1 ou 2, **caractérisé** en ce qu'il comprend un transformateur dont l'enroulement primaire est destiné à être relié au réseau, cet enroulement étant découplé de l'entrée du circuit sensible à l'impédance du réseau par un élément dont l'impédance est très élevée lorsqu' il n'est soumis qu'à la tension de la source de courant indépendante, mais qui permet le passage du courant alternatif d'alimentation du transformateur.

### Revendications

1. Dispositif pour contrôler si un appareil ou un circuit est en liaison avec un réseau de distribution électrique, **caractérisé** en ce qu'il comprend un

# FIG.1

EP 0 324 318 A1

FIG. 2

EP 0 324 318 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENT ABSTRACTS OF JAPAN, vol. 8, no. 204, (P-301)[1641], 18 septembre 1984; & JP-A-59 90 063 (MATSUSHITA DENKO K.K.) 24-05-1984 * Résumé * | 1-3 | H 02 J 9/06 G 01 R 31/02 |
| Y | EP-A-0 028 591 (NIFE JUNGNER AB) * Résumé; page 4, lignes 29-30; figure 2 * | 1-3 | |

DOMAINES TECHNIQUES
RECHERCHES (Int. Cl.4)

H 02 J
G 01 R

Le présent rapport a été établi pour toutes les revendications

| Lieu de la recherche | Date d'achèvement de la recherche | Examinateur |
|---|---|---|
| LA HAYE | 20-04-1989 | SCHOBERT D.A.V. |

EPO FORM 1503 03.82 (P0402)